Europäisches Patentamt

European Patent Office

Office européen des brevets

(19)

(11) **EP 1 044 082 B1**

(12) **EUROPÄISCHE PATENTSCHRIFT**

(45) Veröffentlichungstag und Bekanntmachung des Hinweises auf die Patenterteilung:
**23.04.2003   Patentblatt 2003/17**

(21) Anmeldenummer: **98956935.5**

(22) Anmeldetag: **19.11.1998**

(51) Int Cl.⁷: $B23K\ 1/005$

(86) Internationale Anmeldenummer:
**PCT/EP98/07432**

(87) Internationale Veröffentlichungsnummer:
**WO 99/026754 (03.06.1999 Gazette 1999/22)**

(54) **VERFAHREN ZUR LÖTBEFESTIGUNG MINIATURISIERTER BAUTEILE AUF EINER GRUNDPLATTE**

METHOD FOR FIXING MINIATURISED COMPONENTS ONTO A BASE PLATE BY SOLDERING

PROCEDE POUR FIXER PAR BRASAGE DES COMPOSANTS MINIATURISES SUR UNE PLATINE

(84) Benannte Vertragsstaaten:
**CH DE FR GB LI**

(30) Priorität: **20.11.1997  DE 19751352**

(43) Veröffentlichungstag der Anmeldung:
**18.10.2000   Patentblatt 2000/42**

(73) Patentinhaber: **Leica Geosystems AG**
**9435 Heerbrugg (CH)**

(72) Erfinder: **REMY DE GRAFFENRIED, Christian**
**CH-1814 La Tour-de-Peilz (CH)**

(74) Vertreter: **Kaminski, Susanne et al**
**Büchel, Kaminski & Partner**
**Austrasse 79**
**9490 Vaduz (LI)**

(56) Entgegenhaltungen:
**EP-A- 0 577 589          US-A- 3 764 772**

## Beschreibung

Die vorliegende Erfindung betrifft ein Verfahren zur Befestigung eines insbesondere modular gefaßten, miniaturisierten Bauteils auf einer Grundplatte durch eine Lötverbindung.

In der DE-A-195 33 426 ist ein mechanisches Befestigungssysten für modular, bevorzugt in einem Gehäuse, gefaßte , mikrooptische Elemente auf einer Grundplatte zur Herstellung eines optischen bzw. optoelektronischen Layouts beschrieben. Eine Halterung ist mit einer mittigen Plattform ausgebildet, die den Einzelmodul trägt. An der Plattform sind bevorzugt über Scharniere mindestens drei Beine angelenkt, die an der Grundplatte z.B. durch Laserpunktschweißen oder Löten befestigt werden. Dieses bekannte Befestigungssystem erlaubt, optische Bauteile in einem weiten Temperaturbereich schock- und vibrationsstabil zu halten.

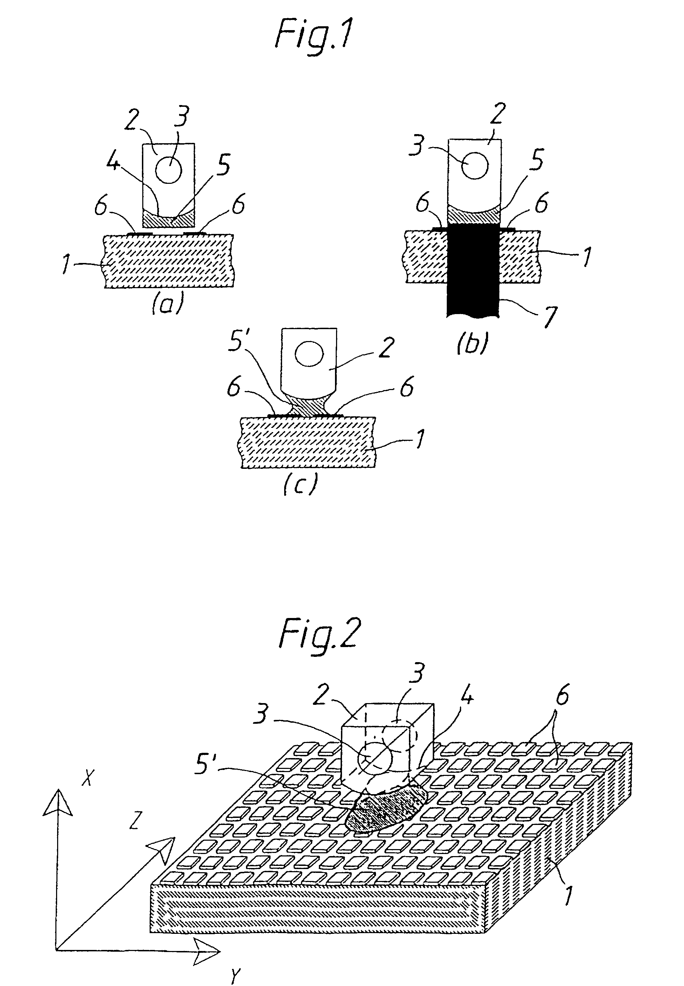

Aus dem Stand der Technik ist es bekannt, Mikrolötungen mit Laserstrahlen durchzuführen, wobei sich die beiden zu verbindenden Teile berühren, vgl. J.L. Jellison et al.: "Microsoldering and microminiature welding with lasers", Microjoining, Sept. 1988, S. 99-107. Die Prüfung von Lötverbindungen von beim Löten gegeneinander gedrückten Anschlußflächen zweier Bauteile bei hoher Packungsdichte ist ein wichtiges Problem. Zur Herstellung der Lötverbindung werden Lötperlen an den Anschlußflächen eines Chip-Bauteils und an den zugeordneten Anschlußflächen eines z.B. Substrats oder einer Grundplatte hergestellt. Die jeweiligen Anschlußflächen werden in Berührungseingriff gebracht und bis zum Schmelzen des Lötmaterials erwärmt, vgl. P.A. Burdett et al.: "Inspection technique for flip chip bonded devices", Microjoining, Sept. 1988, S. 39-45 und 47-50. Zur Abrundung des Standes der Technik wird auf Stockham, Microjoining, Sept. 1988. S. 27, Fig. 1 und 2, hingewiesen.

Es ist Aufgabe der vorliegenden Erfindung, ein Verfahren zum Verbinden zweier Teile durch Löten anzugeben, das eine äußerst genau Positionierung erlaubt.

Diese Aufgabe wird erfindungsgemäß durch die Merkmale des Anspruchs 1 gelöst.

Vorteilhafte Weiterbildungen des Erfindungsgegenstands ergeben sich aus den Unteransprüchen.

In vorteilhafter Weise ermöglicht das erfindungsgemäße Verfahren eine lötflußmittelfreie und genaue Lötverbindung von insbesondere optischen, optoelektronischen, elektronischen und miniaturisierten, mechanischen Bauteilen auf einer Grundplatte entlang sechs Freiheitsgraden. Insbesondere kann das erfindungsgemäße Verfahren vorteilhaft einfach ausgeführt werden.

Die bei dem erfindungsgemäßen Lötverfahren verwendete Energie wird von einem Energiefluß unterschiedlicher Art, wie einem Laserbündel, UV-Bestrahlung oder einem magnetischen Feld geliefert, das durch eine Induktanz hoher Frequenz erzeugt wird. In allen Fällen geht der Energiefluß durch die Grundplatte hindurch, um die dünne Lötmaterialschicht zu schmelzen.

Ohne eine Beschränkung vorzunehmen, ist hier dargestellt, auf welche Weise es das neuartige Lötverfahren ermöglicht, optische Elemente auf einer Grundplatte unter Verwendung eines Laserbündels zu befestigen. Die optischen Elemente werden innerhalb eines Gehäuses befestigt, dessen zu verbindende Seite - nachfolgend Basis genannt - mit einem Lötmaterial, wie Lotzinn oder eine Lötzinnlegierung, beschichtet ist. Die Grundplatte muß eine gute Lichtdurchlässigkeit innerhalb des Wellenlängenbereiches der verwendeten Laserstrahlen aufweisen. Die dem Gehäuse zugewandte Oberfläche der Grundplatte ist bevorzugt - zumindest teilweise - mit einem gitterförmigen Metallmuster beschichtet. Das zu befestigende Gehäuse wird in einem geeigneten Abstand, beispielsweise einige Zehntel Millimeter, oberhalb der Grundplatte ohne mechanische Berührung der Grundplatte gehalten. Wenn der Laserstrahl von unten gegen die Oberfläche der Grundplatte nach oben gerichtet wird, erwärmt ein Anteil seiner Energie das Metallmuster, während der Rest durch die freien Flächen des Musters hindurchgeht, die Basis des Gehäuses erreicht und das auf der Basis vorhandene Lötmaterial zum Schmelzen bringt, wodurch ein Lötmaterialtropfen gebildet wird. Der Tropfen füllt den Zwischenraum zwischen der Grundplatte und der Basis des Gehäuses, wodurch nach der Erstarrung eine feste und gute Lötverbindung erzeugt wird.

Der Erfindungsgegenstand wird nachfolgend anhand von Beispielen unter Bezugnahme auf die Zeichnungen näher erläutert. Es zeigen:

Fig. 1a - 1c:     die Bildung eines Lötmaterialtropfens;

Fig.2:     eine perspektivische Ansicht der Anordnung eines Gehäuses mit einer zylinderförmigen Basisfläche auf einer mit einem Muster versehenen Grundplatte;

Fig.3:     eine perspektivische Ansicht der Anordnung eines Gehäuses mit einer sphärischen Basisfläche auf einer mit einem Muster versehenen Grundplatte, und

Fig.4a - 4d:     eine Lötverbindung unter Verwendung eines großflächigen und eines kleinflächigen Musters auf der Grundplatte.

Zum besseren Verständnis wird hier beschrieben, wie dieses neue Verfahren erfolgreich verwendet werden kann, um eine Befestigung miniatunsierter optischer Elemente durchzuführen. Diese Technik ist besonders geeignet, mikrooptische Teile entlang von sechs Freiheitsgraden mit hoher Genauigkeit einzustellen und zu befestigen. Des weiteren ermöglicht dieses Verfahren, das lötflußmittelfrei ist, die Gefahr einer Verschmutzung empfindlicher optischer Elemente, wie einer freiliegenden, in dem Gehäuse enthaltenen Laserdiode, zu begrenzen. Gegebenenfalls vorhandenes Lötflußmittel würde, wenn es von dem Laserstrahl erreicht wird, tatsächlich sofort unter starker Rauchbildung verdampfen. Des weiteren verlangt eine Lötflußmitteltechnik stets eine Reinigungsphase, um eine mögliche Oxidierung des Lötmatenals aufgrund von Lötflußmittelabscheidungen zu verhindern. Dies würde im Fall optischer Elemente eine besondere Sorgfalt verlangen.

Bei dem folgenden Ausführungsbeispiel des erfindungsgemäßen Lötverfahrens werden zwei getrennte Teile betrachtet, nämlich ein Gehäuse und eine Grundplatte. Das Gehäuse enthält ein optisches Element, das in diesem entweder durch Kleben, oder irgendeine mechanische Wirkung in seiner Lage gehalten ist.

Unterschiedliche Materialien können verwendet werden, wobei aber auf eine niedrige Wärmeleitfähigkeit geachtet werden sollte, um zu verhindern, daß das optische Element beschädigt wird, wenn der Laserstrahl die Lötmaterialschicht erwärmt. Ein hoher Wärmewiderstand zwischen dem Gehäusekörper und seiner Basis gestattet, die übertragene Energiemenge zu verringern, die notwendig ist, um die dünne Lötmaterialschicht zu schmelzen, da die Wärme in einem begrenzten Bereich lokalisiert bleibt, statt in das Gehäuse bzw. die gesamte Halteeinrichtung zu diffundieren. Diese Eigenschaft kann entweder mit einem Werkstoff erreicht werden, der selbst eine niedrige Wärmeleitfähigkeit aufweist, oder mit einer Isolation zwischen dem Boden bzw. der Basis des Gehäuses oder einer Halteeinrichtung und deren restlichem Teil. Der Wärmewiderstand kann auch geometrisch erhöht werden, indem beispielsweise Löcher zwischen dem Körper und seiner Basis gebohrt werden, so daß Verbindungsstege mit schlechter Wärmeleitung entstehen.

Nachfolgend wird auf die Fig. 1a - 1c und Fig. 2 Bezug genommen.

Fig. 1a zeigt eine Grundplatte 1 und ein oberhalb von ihr angeordnetes Gehäuse 2, das ein Loch 3 für den Durchgang eines Lichtstrahls aufweist. Die Basis 4 des Gehäuses bzw. des Bauteils 2 ist mit einer zylindrischen Fläche ausgebildet, die mit einer Lötmaterialschicht 5 überzogen ist. Die Oberseite der Grundplatte 1 ist teilweise mit einer dünnen Metallschicht 6 in einem Muster beschichtet, wodurch metallfreie Bereiche vorhanden sind, durch die Strahlungsenergie hindurchtreten kann.

In Fig. 1b ist zusätzlich ein Laserstrahl 7 dargestellt, der von der Unterseite der Grundplatte 1 her durch sie hindurchgeht und auf die Metallschicht 6 auf der Oberfläche der Grundplatte 1 und durch die metallfreien Bereiche der Grundplatte hindurch auf die Lötmaterialschicht 5 auf der Basis 4 des Gehäuses 2 auftrifft.

Fig. 1c zeigt den Zustand nach dem lokalen Schmelzen der Lötmaterialschicht 5, wobei eine Verbindung mit der Metallschicht 6 der Grundplatte 1 durch Überbrückung des Zwischenraums zwischen der Metallschicht 6 und der Basis 4 des Gehäuses 2 hergestellt ist.

Fig. 2 zeigt in perspektivischer Ansicht die Anordnung des Gehäuses 2 auf der Grundplatte 1. In den Fig. 1a - 1c ist die Metallschicht 6 im Schnitt zu sehen, wodurch die flächige Ausgestaltung nicht erkennbar ist. Man erkennt in Fig. 2, daß das Muster der Metallschicht 6 gleichförmig von kleinen Flächenelementen gebildet ist. Zwischen den Flächenelementen kann Strahlungsenergie zum Schmelzen des Lötmaterials hinduchgehen. Zur Veranschaulichung der Rotationsmoglichkeiten vor bzw. bei der Befestigung ist in Fig. 2 ein kartesisches Koordinatensystem X, Y, Z dargestellt.

Betrachtet man die Bildung eines kleinen Flüssigkeitstropfens, beispielsweise einige wenige mm$^3$, so kann das Eigengewicht - verglichen mit der Oberflächenspannung - vernachlässigt werden. Aus diesem Grund erhält die Lötmaterialschicht eine bestimmte Form, die so ausgewählt werden soll, daß sie mit der Oberflächenspannung des Lötmaterials wechselwirkt, um einen dicken Lötmaterialtropfen zu bilden. Die Lötmaterialschicht muß ein ausreichendes Volumen liefern, um den Zwischenraum zwischen dem Gehäuse und der Grundplatte auszufüllen. Trotz dieser Vorgabe darf das Lötmaterial das Gehäuse nicht behindern, entlang sechs Freiheitsgraden in seiner räumlichen Position eingestellt werden zu können.

Es wurde eine runde Basis wegen der geometrischen Symmetrie während einer Nick- und Rolleinstellung gewählt. Da eine Drehsymmetrie der Lötverbindung zwischen der Basis des Gehäuses und der Grundplatte vorhanden ist, gestattet diese beständige, mechanische Verbindungseigenschaften der Lötbefestigung in irgendeiner Konfiguration, was für eine gute Wiederholbarkeit des Verfahrens (symmetrische Kräfteverteilung) wichtig ist.

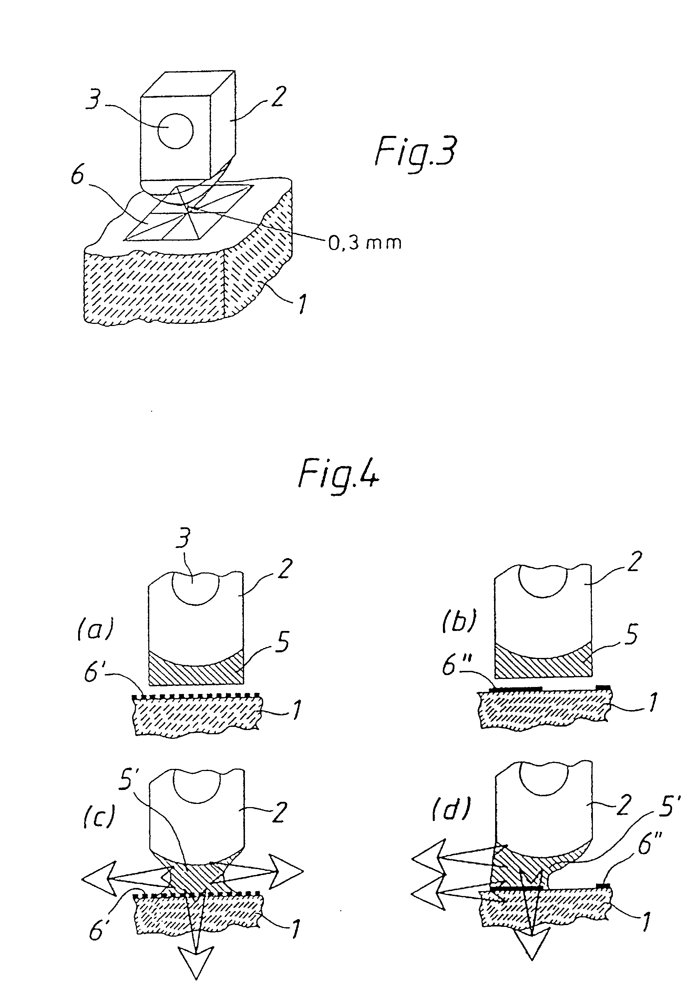

Eine sphärische Basis, wie sie in Fig. 3 gezeigt ist, stellt die beste Lösung dar. Jedoch wird auf manchen technischen Gebieten keine große, winkelmäßige Positionierungsgenauigkeit entlang aller drei Achsen verlangt, so daß die Verwendung eines Gehäuses, das durch eine zylindrische Basis (vgl. Fig. 1) gekennzeichnet ist, von Vorteil sein kann, da es einfach und mit niedrigen Kosten hergestellt werden kann.

Die Lötmittelschicht weist einen niedrigen Schmelzpunkt auf, um die Schmelzwärmemenge zu begrenzen, die von dem Laserstrahl übertragen wird, damit eine Beschädigung des optischen Elements verhindert wird. Das verwendete Lötmaterial muß eine angemessene Befeuchtbarkeit des Metallmusters, mit dem die Grundplatte beschichtet ist, ohne die Notwendigkeit der Verwendung irgendeines Lötmaterials sicherstellen. Von dem Lötmaterial wird angenommen, daß es fortwährend an der Grundplatte und der Halteeinrichtung anhaftet. Es muß auch solche mechanischen Eigenschaften aufweisen, die eine zeitbeständige, feste Verbindung sicherstellen, um beispielsweise eine Kriechwirkung während der auftretenden Wärmeschwankungen oder -perioden zu vermeiden. Die Lötmaterialschicht muß auch eine flache Oberflächenbasis haben, um die Schattenwirkung auszuschließen, die eine runde Lötmaterialbasis in dem Fall beeinflussen würde, wenn der Laserstrahl nicht senkrecht auf die Basis selbst geschickt wird.

Der Werkstoff, der für die Herstellung der Grundplatte verwendet wird, muß in diesem besonderen Fall durch eine niedrige Laserstrahlabsorption gekennzeichnet sein. Er muß auch wirksam Temperaturschocks aushalten, da, wenn der Laserstrahl durch die Grundplatte hindurchgeschickt wird, ein Teil der mitgeführten Energie von einem örtlichen Bereich der Grundplattenbeschichtung absorbiert wird, der infolgedessen einer schnellen Temperaturzunahme ausgesetzt wird. Die Beschichtung ist ein normalerweise gut leitendes Material, üblicherweise ein Metall, so daß es auf die Grundplatte eine gewisse Energiemenge überträgt, die eine örtliche und merkliche Temperaturzunahme bewirkt. Bei einer Grundplatte, die geeigneterweise durch eine schlechte Wärmeleitfähigkeit gekennzeichnet ist - beispielsweise Glas, Keramik oder Glaskeramik -, kann sich die Energie nicht entlang der gesamten Grundplatte verteilen und bleibt in einem örtlichen Teil der Grundplatte konzentriert, was ohne weiteres dazu führen kann, daß die Grundplatte aufgrund vorliegender Temperaturgradienten bricht. Des weiteren ist es von Bedeutung, daß Temperaturänderungen die gegenseitigen Abstände der Bauteile und gegebenenfalls deren Brennweiten ändern können, so daß es notwendig ist, daß das Material der Grundplatte einen niedrigen Wärmeausdehnungskoeffizienten aufweist. Deshalb ist es notwendig, ein Grundplattenmaterial zu verwenden, das einen großen Wärmestoßwiderstand aufweist, wie z.B. Pyrex, Robax oder Xerodor.

Die Grundplatte muß derart geeignet sein, daß sie mit einem dünnen und nicht durchgehenden Metallmuster beschichtet werden kann, das ohne weiteres durch geschmolzenes Lötmaterial befeuchtet wird. Die Musterstruktur kann von einem Gitter aus Flächenelementen oder einer Reihe von sich bevorzugt senkrecht schneidenden Streifen gebildet sein, die ein Gitter oder sonst irgendeine Struktur bilden, die durch einen gleichförmigen Wechsel von Metallbereichen und freien Bereichen gekennzeichnet ist. Die Flächenelemente können eine rechteckige Form, eine quadratische Form, eine runde Form oder irgendeine Form annehmen, die geeignet ist, bei diesem Verfahren verwendet zu werden, und die durch die technische Ausführbarkeit gekennzeichnet ist.

Beispielsweise können die Grundabmessungen der mit einem Muster versehenen Grundplatte die Musterweite und der Musterzwischenraum sein. Bei einem quadratischen Muster mit senkrecht zueinander verlaufenden, gleichbeabstandeten Metallstreifen gleicher Breite wird als Schrittweite die Summe aus der Streifenbreite plus dem Streifenabstand definiert. Die Weite des Musters ist der Abstand zwischen zwei Streifen. Das Öffnungsverhältnis stellt die Beziehung zwischen dem quadratischen metallisierten und dem nichtmetallisierten Bereich dar.

Es gilt:

$$\text{Öffnungsverhältnis} = (\text{Schrittweite} - \text{Weite})^2/\text{Schrittweite}^2.$$

Entsprechendes gilt im Falle einer Rasteranordnung quadratischer Flächenelemente.

Die metallisierten Musterbereiche liefern einen wirksamen Befestigungsbereich, während es die metallfreien Bereiche ermöglichen, daß eine ausreichende Energiemenge durch die Grundplatte hindurchgehen kann, um das Lötmaterial zu schmelzen. Die metallisierten Musterabmessungen und die Struktur können frei - gemäß der technologischen Ausführbarkeit und der Wahrung eines bestimmten Öffnungsverhältnisses - gewählt werden.

Die Musterschrittweite sollte wenigstens eine Größenordnung kleiner als die Abmessungen des Gehäuses sein. Dies stellt eine symmetrische und gleichförmige Lötverbindungs-Ausgestaltung zwischen der Grundplatte und der Gehäusebasis sicher.

In diesem Zusammenhang wird auf die Fig. 4a - 4d verwiesen. In den Fig. 4a und 4c ist die Grundplatte 1 mit einem feinen Metallmuster 6' versehen. Es ist zu erkennen, daß die durch Pfeile dargestellten Kräfte auf das geschmolzene Lötmaterial 5' symmetrisch wirken und zu einer im wesentlichen zentrierten Lötmaterialverbindung führen. Bei einem groben Metallmuster 6", wie es in den Fig. 4b und 4d gezeigt ist, ergibt sich eine asymmetrische Kräfteverteilung, die zu einer außermittigen Lötbefestigung führt.

Somit kann eine freie Positionierung des Gehäuses auf der gesamten Oberfläche der Grundplatte erreicht werden und irgendwelche vorbestimmten geometrischen Einschränkungen werden ausgeschlossen. Des weiteren läßt sich das Lötverfahren nach der Erfindung einfach ausführen.

Das metallisierte Muster wird üblicherweise von mehreren Schichten gebildet, die sich voneinander in ihrer Dicke und Materialzusammensetzung unterscheiden. Üblicherweise gibt es drei Schichten, wobei es die Aufgabe der ersten Schicht ist, im allgemeinen ein gutes Anhaften an der Oberfläche der Grundplatte sicherzustellen. Die zweite Schicht, die im allgemeinen viel dicker als die erste Schicht ist, stellt das Substratmaterial dar, das mit dem geschmolzenen Lötmaterial wechselwirkt, um die Befestigung durchzuführen. Die dritte Schicht, die normalerweise so dünn wie die erste ist, liefert einen Schutz gegenüber einer Oxidation durch den Luftsauerstoff. Da das Lötmaterial stets in Richtung zu den erwärmten Bereichen strebt und fließt, ist es sehr wichtig, beide Teile zu erwärmen, um eine feste Verbindung zu erreichen. Das hier dargestellte neue Lötverfahren ermöglicht es, dieses Problem zu überwinden.

Der Laserstrahl wird beim Durchgang durch die Grundplatte geteilt: Ein Teil der Energie geht durch die nicht metallisierten Bereiche der Grundplatte hindurch, während der restliche Teil teilweise von den metallisierten Bereichen absorbiert und teilweise von ihnen reflektiert wird. Die Laserenergiemenge, die durch die Grundplatte hindurchgeht, muß ausreichend sein, um die Lötmaterialschicht auf der Basis des Gehäuses zu schmelzen. Das von den metallisierten Bereichen der Grundplatte absorbierte Licht darf sie durch Überhitzung nicht beschädigen. Das Verhältnis von reflektierter zu absorbierter Strahlungsenergie hängt von den physikalischen Eigenschaften des Materials der Metallmusterschicht ab.

Das Öffnungsverhältnis wird durch die geometrischen Eigenschaften des Musters bestimmt (Schrittweite, Weite).

Die Form des Laserflecks, der bei dem Lötverfahren verwendet wird, ist durch die Abmessungen bestimmt, die am besten zu der Gehäusebasis passen, da eine gleichförmige Erwärmung verhindert, daß das Lötmaterial eine asymmetrische Flüssigkeit und Festigkeit erzeugt. Es kann auch ein überdimensionierter Laserfleck verwendet werden, der durch eine Blende begrenzt wird. Die Intensität des Laserflecks muß beschränkt werden, weil sonst ein Teil des Lötmaterials unmittelbar verdampft werden kann. Infolgedessen muß die Erwärmungsdauer so gleichmäßig wie möglich sein und sollte wenigstens einige Sekunden andauern. Die von dem Laserstrahl gelieferte Energiemenge sollte die benötigte Schmelzwärme nicht stark überschreiten, da sonst auf dem geschmolzenen Lötmaterialtropfen eine Oxidschicht erzeugt wird, die unausweichlich die Befeuchtungsfähigkeit des Lötmaterials behindert.

Der Laserfleck sollte zumindest mit seiner Form an die Querschnittsform der zu bestrahlenden Fläche, d.h. der Basis bzw. der Halteeinrichtung, durch Bewegung des Laserkopfes oder durch die Verwendung von Spiegeln oder anderen optischen Strahlbeeinflussungsmitteln angepaßt werden. Wenn der Basisquerschnitt des Gehäuses bzw. der Halteeinrichtung rechteckig ist, wobei eine Seite doppelt so lang wie die andere ist, sollte die Form des Laserstrahlflecks keine Kreisfläche, sondern vielmehr eine Ellipsenfläche aufweisen, damit die gesamte Basisoberfläche einem geringeren Energieverlust als in dem Fall einer Überdeckung mit einem kreisförmigen Laserfleck ausgesetzt wird.

Bei der Verwendung eines nicht kollimierten Laserbündels muß dafür Sorge getragen werden, daß der Laserfleck, der auf das metallisierte Muster projiziert wird, nicht zu klein ist. Wenn der Fleck zu klein ist, besteht die Gefahr, daß das metallisierte Muster durch die zu große Intensität des Laserflecks beschädigt wird. Wenn im Gegensatz dazu der Fleck zu groß ist, besteht andererseits die Gefahr daß ein angrenzendes und bereits gelötetes Gehäuse beschädigt oder sogar abgelötet wird. Jedoch werden mit einem kollimierten Laserbündel die zwei oben genannten Probleme gelöst. Ferner sind dreidimensionale Ausgestaltungen auch möglich, indem zwei oder mehrere mit Muster versehene Grund- bzw. Glasplatten mit mechanischen Abstandsstücken zwischen ihnen übereinander angeordnet werden. Das Muster auf jeder Grundplatte muß so ausgelegt werden, daß es dem kollimierten Laserbündel möglich ist, die obere Grundplatte an den entsprechenden Stellen zu erreichen.

Eine Schrumpfung des Lötmaterials während der Abkühlungsphase bei der Befestigung ändert unvermeidbar die Gehäuseeinstellung entlang der vertikalen Achse. Die Schrumpfung zeigt eine sehr gute Wiederholbarkeit und kann als Funktion des Zwischenraums zwischen der Grundplatte und der Gehäusebasis kalibriert werden. Eine Lösung, diese vertikale Schrumpfung zu überwinden, ist, sie selbsttätig auszugleichen, bevor das Lötverfahren beginnt, d.h. zum Beispiel, die Größe der Schrumpfung bei der Konstruktion bereits zu berücksichtigen.

Die seitliche und die Winkelgenauigkeit werden durch die Lötmaterialschrumpfung wegen der sphärischen oder zylindrischen Symmetrie der Gehäusebasis und des sehr feinen Musters nicht geändert, das auf der Grundplatte abgeschieden ist, das - verglichen mit der Abmessung des Gehäuses - nahezu kontinuierlich ist.

Das erfindungsgemäße Lötverfahren weist eine Befestigungsgenauigkeit im Bereich von 0,1 µm in allen sechs räumlichen Freiheitsgraden und eine Winkelgenauigkeit von 0.1 mrad auf. Das Verfahren ist besonders zur Befestigung kleiner, optischer Bauteile geeignet, da das Genauigkeitsmaß entlang den sechs Freiheitsgraden mit anderen Techniken, wie z.B. einer passiven Ausrichtung (Silicium V-Nut), nicht erreicht werden kann.

Eine aktive Einstellung der optischen Elemente ermöglicht eine Positionierungsgenauigkeit von weniger als 1 µm. Dies wird erreichbar, da die Positionierung jedes Bauteils in Bezug relativ zu der optischen Achse des vorhergehenden Bauteils erfolgt, das bereits auf der Grundplatte befestigt worden ist. Somit sind die Bearbeitungsgenauigkeit des Gehäuses und die Befestigungsgenauigkeit von jedem optischen Bauteil in ihm nicht kritisch, da große mechanische Toleranzen ohne weiteres während des aktiven Zusammenbaus der nachfolgenden Bauteile ausgeglichen werden können.

Das Verfahren ist besonders zur Verwendung in automatischen Montagestationen geeignet, da alle erforderlichen Aufgaben durch Roboter ausgeführt werden können, die mit einigen Positionierungssensoren versehen sind. Jedes Bauteil wird in dem Raum durch einen Roboter entlang den sechs Freiheitsgraden positioniert und festgelegt.

Die hier beschriebene TREMO-SMD-Technik ist ähnlich der bekannten optischen SMD-Technik (DE-A1-195 33 426), die die Philosophie des flexiblen und aktiven Zusammenbaus von optischen Bauteilen mit hoher Genauigkeit und entlang sechs Freiheitsgraden betrifft. Aufgrund ihrer miniaturisierten Abmessungen ist die neue TREMO-SMD-Technik geeignet, in anderen Bereichen als die O-SMD-Technik verwendet zu werden. Die Haupteigenschaften der TREMO-SMD-Technik sind:

- sie ist für dreidimensionale Ausgestaltungen geeignet;
- sie ist zur Befestigung sehr kleiner optischer Elemente geeignet (Abmessungen in der Größenordnung von 1 mm);
- es besteht keine Gefahr einer Dampf- oder Teilchenverunreinigung empfindlicher optischer Elemente (freiliegende Laserdiode);
- die Befestigungsgenauigkeit ist hoch (± 0,1 μm);
- die Einstellung von jedem Bauteil - keine mechanische Berührung zwischen der Gehäusebasis und der Grundplatte und keine mechanische Kraft vor der Befestigung, keine Anhaft- und Rutschwirkung - ist möglich;
- der Befestigungsvorgang kann im allgemeinen ohne Beeinträchtigung durch die Energiezufuhr - die Befestigungsenergie wird von unterhalb der Grundplatte geliefert - erfolgen;
- die Grundplatte weist eine gute Maßstabilität auf - Glas oder Keramik mit kleinem, linearen Wärmeausdehnungskoeffizienten:
- es sind eine einfache Gehäusekonstruktion und eine leichte Miniaturisierung möglich.

Diese neue Befestigungstechnik kann auch im Fall eines dreidimensionalen Zusammenbaus verwendet werden. Hierzu werden die Bauteile auf den Grundplatten angeordnet werden, die sich auf unterschiedlichen Höhen befinden, und die große Laserstrahldurchlässigkeit wird ausgenutzt, damit der Laserstrahl durch die verschiedenen Grundplatten hindurchgeht, bevor das in Betracht gezogene Bauteil auf einer höheren Grundplatte erreicht wird.
Grundsätzlich kann erfindungsgemäß auch die Metallmusterschicht auf der Grundplatte mit einer Schicht aus einem Lötmaterial beschichtet werden. Hierdurch kann der Lötvorgang erleichtert werden. Die Energiezufuhr zu der Metallschicht ist entsprechend vorzunehmen, insbesondere ist gegebenenfalls deren Strahlungsabsorption zu erhöhen, z.B. dadurch, daß die Beaufschlagungsseite dunkler gemacht wird.

**Bezugszeichenliste**

1    Grundplatte

2    Bauteil (Gehäuse)

3    Loch

4    Basis von (2)

5    Lötmaterialschicht

5'    (geschmolzenes) Lötmaterial

6    (dünne) Metallschicht

6'    Metallmuster

6"    (grobes) Metallmuster

7    Laserstrahl

**Patentansprüche**

**1.** Verfahren zur Befestigung eines insbesondere modular gefaßten, miniaturisierten Bauteils auf einer Grundplatte durch eine Lötverbindung, wobei

(a) eine Seite (4) eines Bauteils (2) mit einer Schicht (5) aus Lötmaterial beschichtet wird;

(b) die Grundplatte (1)zumindest teilweise mit einer Schicht aus Metall (6) beschichtet wird;

(c) das Bauteil (2) oberhalb der Grundplatte (1) angeordnet wird, wobei sich die Metallschicht (6) und die Lötmaterialschicht (5) in berührungsfreier, vertikal beabstandeter Gegenüberlage befinden; und

(d) Wärmeenergie von der Seite der Grundplatte (1) zum Schmelzen von Lötmaterial der Lötmaterialschicht (5) auf der Seite (4) des Bauteils bis zu einer Tropfenbildung zugeführt wird, wodurch der Lötmaterialtropfen (5') den Zwischenraum zwischen dem Bauteil (2) und der Grundplatte (1) zur gegenseitigen Befestigung füllt.

2. Verfahren nach Anspruch 1, **dadurch gekennzeichnet, daß**
die Metallschicht (6) auf der Grundplatte (1) in einem Muster (6' bzw. 6") angeordnet wird.

3. Verfahren nach Anspruch 2, **dadurch gekennzeichnet,daß** das Muster (6', 6") der Metallschicht regelmäßig ausgebildet ist.

4. Verfahren nach Anspruch 2, **dadurch gekennzeichnet, daß**
das Muster (6', 6") der Metallschicht unregelmäßig ausgebildet wird.

5. Verfahren nach Anspruch 2, **dadurch gekennzeichnet, daß**
das Muster (6', 6") der Metallschicht als Gittermuster oder in der Form eines regelmäßigen Musters von einzelnen Flächenelementen (6) ausgebildet wird.

6. Verfahren nach Anspruch 1, **dadurch gekennzeichnet, daß**
für die mit Lötmaterial beschichtete Seite (4) des Bauteils (2) eine nach außen gewölbte Seite verwendet wird.

7. Verfahren nach Anspruch 6, **dadurch gekennzeichnet, daß** für die mit Lötmaterial beschichtete Seite (4) des Bauteils (2) eine nach außen sphärisch gewölbte Seite verwendet wird.

8. Verfahren nach Anspruch 6, **dadurch gekennzeichnet, daß** für die mit Lötmaterial beschichtete Seite (4) des Bauteils (2) eine nach außen zylindrisch gewölbte Seite verwendet wird.

9. Verfahren nach Anspruch 1, **dadurch gekennzeichnet, daß**
für die mit Lötmaterial beschichtete Seite (4) des Bauteils (2) eine ebene Seite verwendet wird.

10. Verfahren nach Anspruch 1, **dadurch gekennzeichnet, daß** zur Schmelzerwärmung des Lötmaterials ein Strahlenbündel elektromagnetischer Wellen durch die Grundplatte (1) hindurch auf die Lötmaterialschicht (5) des Bauteils (2) gerichtet wird.

11. Verfahren nach Anspruch 10, **dadurch gekennzeichnet, daß**
das Strahlenbündel ein Laserlichtbündel (7) oder UV-Lichtbündel ist.

12. Verfahren nach Anspruch 11, **dadurch gekennzeichnet, daß**
dem Strahlenbündel im Beaufschlagungsbereich ein elliptischer Querschnitt verliehen wird.

13. Verfahren nach Anspruch 1, **dadurch gekennzeichnet, daß** man zur Schmelzerwärmung des Lotmaterials einen elektrischen HF-Strom durch die Metallschicht (6, 6', 6") der Grundplatte (1) fließen läßt, wodurch durch Induktionserwarmung eine Tropfenbildung von Lötmaterial an der mit Lötmaterial beschichteten Seite (4) des Bauteils (2) hervorgerufen wird.

14. Verfahren nach einem der Ansprüche 1-13, **dadurch gekennzeichnet, daß** die Grundplatte (1) als eine mehrschichtige Verbundplatte hergestellt wird.

15. Verfahren nach einem der vorherigen Ansprüche, **dadurch gekennzeichnet, daß** die Grundplatte (1) aus einem für elektromagnetische Wellen durchlässigen Material hergestellt wird.

16. Verfahren nach einem der Ansprüche 1 bis 13 oder 14 oder 15, **dadurch gekennzeichnet, daß** oberhalb einer weiteren mit einer Metallschicht versehenen Grundplatte ein weiteres mit einer Lötmaterialschicht versehenes, an der weiteren Grundplatte zu befestigendes Bauteil angeordnet wird, wobei sich die Metallschicht und die Lötmaterialschicht in berührungsfreier, vertikal beabstandeter Gegenüberlage befinden, und daß die weitere Grundplatte oberhalb der Grundplatte (1) angeordnet wird und ein Strahlenbündel elektromagnetischer Wellen durch beide Grundplatten hindurch auf die Lötmaterialschicht des weiteren Bauteils zu deren Schmelzerwärmung gerichtet wird, um einen Lötmaterialtropfen (5') zur Befestigung an der weiteren Grundplatte zu bilden.

**Claims**

1. Method for fixing a miniaturized component, in particular assembled in a modular manner, on a baseplate by a solder joint,

   (a) a side (4) of a component (2) being coated with a layer (5) of solder material;
   (b) the baseplate (1) being coated at least partly with a layer of metal (6);
   (c) the component (2) being arranged above the baseplate (1), the metal layer (6) and the layer (5) of solder material being a vertical distance apart and not in contact with one another; and
   (d) heat energy being supplied from the side of the baseplate (1) for melting solder material of the layer (5) of solder material on the side (4) of the component until drop formation, with the result that the drop (5') of solder material fills the space between the component (2) and the baseplate (1) for mutual fixing.

2. Method according to Claim 1, **characterized in that** the metal layer (6) on the baseplate (1) is arranged in a pattern (6' or 6'').

3. Method according to Claim 2, **characterized in that** the pattern (6', 6'') of the metal layer is regularly formed.

4. Method according to Claim 2, **characterized in that** the pattern (6', 6'') of the metal layer is irregularly formed.

5. Method according to Claim 2, **characterized in that** the pattern (6', 6'') of the metal layer is in the form of a grid pattern or in the form of a regular pattern of individual planar elements (6).

6. Method according to Claim 1, **characterized in that** a convex side is used for that side (4) of the component (2) which is coated with solder material.

7. Method according to Claim 6, **characterized in that** a side curved spherically outwards is used for that side (4) of the component (2) which is coated with solder material.

8. Method according to Claim 6, **characterized in that** a side curved cylindrically outwards is used for that side (4) of the component (2) which is coated with solder material.

9. Method according to Claim 1, **characterized in that** a flat side is used for that side (4) of the component (2) which is coated with solder material.

10. Method according to Claim 1, **characterized in that** a beam of electromagnetic waves is directed through the baseplate (1) onto the layer (5) of solder material for heating the solder material until it melts.

11. Method according to Claim 10, **characterized in that** the beam is a laser light beam (7) or UV light beam.

12. Method according to Claim 11, **characterized in that** an elliptical cross-section is imparted to the beam in the region of incidence.

13. Method according to Claim 1, **characterized in that** an electrical HF current is allowed to flow through the metal layer (6, 6', 6'') of the baseplate (1) for heating the solder material until it melts, with the result that induction heating causes drop formation of solder material on that side (4) of the component (2) which is coated with solder material.

14. Method according to any of Claims 1-13, **characterized in that** the baseplate (1) is produced as a multilayer composite plate.

15. Method according to any of the preceding Claims, **characterized in that** the baseplate (1) is produced from a material transparent to electromagnetic waves.

**16.** Method according to any of Claims 1 to 13 or 14 or 15, **characterized in that** a further component provided with a layer of solder material and to be fastened to a further baseplate is arranged above a further baseplate provided with a metal layer, the metal layer and the layer of solder material being a vertical distance apart and not in contact with one another, and that the further baseplate is arranged above the baseplate (1) and a beam of electromagnetic waves is directed through both baseplates onto the layer of solder material of the further component for heating said layer until it melts, in order to form a drop (5') of solder material for fixing to the further baseplate.

**Revendications**

**1.** Un procédé de fixation d'un composant miniaturisé, serti, en particulier de façon modulaire, sur une platine, par une liaison par brasage, où

(a) une face (4) d'un composant (2) est enduite d'une couche (5) en matériau de brasage ;
(b) la platine (1) est enduite au moins partiellement d'une couche en métal (6) ;
(c) le composant (2) est disposé au-dessus de la platine (1), la couche de métal (6) et la couche de métal de brasage (5) se trouvant en confrontation sans contact, espacées verticalement ; et
(d) de l'énergie thermique est amenée depuis le côté de la platine (1) pour produire la mise en fusion du matériau de brasage de la couche de matériau de brasage (5) sur le côté (4) du composant jusqu'à formation d'une goutte, faisant que la goutte de matériau de brasage (5') remplit l'espace intermédiaire existant entre le composant (2) et la platine (1), dans le but de produire une fixation mutuelle.

**2.** Procédé selon la revendication 1, **caractérisé en ce que** la couche de métal (6) est disposée sur la platine (1) selon un motif (6' ou 6").

**3.** Procédé selon la revendication 2, **caractérisé en ce que** le motif (6', 6") de la couche de métal est de conformation régulière.

**4.** Procédé selon la revendication 2, **caractérisé en ce que** le motif (6', 6") de la couche de métal est de conformation irrégulière.

**5.** Procédé selon la revendication 2, **caractérisé en ce que** le motif (6', 6") de la couche de métal est réalisé selon un motif en grille ou sous la forme d'un motif régulier, formé de différents éléments de surface (6).

**6.** Procédé selon la revendication 1, **caractérisé en ce qu'**une face bombée extérieurement est utilisée pour la face (4), enduite de matériau de brasage, du composant (2).

**7.** Procédé selon la revendication 6, **caractérisé en ce qu'**une face bondée extérieurement de façon sphérique est utilisée pour la face (4), enduite de matériau de brasage, du composant (2).

**8.** Procédé selon la revendication 6, **caractérisé en ce qu'**une face bombée extérieurement de façon cylindrique est utilisée pour la face (4), enduite de matériau de brasage, du composant (2).

**9.** Procédé selon la revendication 1, **caractérisé en ce qu'**une face plane est utilisée pour la face (4), enduite de matériau de brasage, du composant (2).

**10.** Procédé selon la revendication 1, **caractérisé en ce que**, pour obtenir le chauffage à fusion du matériau de brasage, on dirige un faisceau de rayons d'ondes électromagnétiques à travers la platine (1), sur la couche de matériau de brasage (5) du composant (2).

**11.** Procédé selon la revendication 10, **caractérisé en ce que** le faisceau de rayons est un faisceau de lumière laser (7) ou un faisceau de lumière UV.

**12.** Procédé selon la revendication 11, **caractérisé en ce qu'**on confère une section transversale elliptique au faisceau de rayons, dans la zone d'exposition.

**13.** Procédé selon la revendication 1, **caractérisé en ce que**, pour obtenir le chauffage à fusion du matériau de brasage, on fait passer un courant électrique HF à travers la couche métallique (6', 6"), faisant que, par un chauffage par induction, une formation de goutte de matériau de brasage sur la face (4), enduite de matériau de brasage, du composant (2) est provoquée.

14. Procédé selon l'une des revendications 1 à 13, **caractérisé en ce que** la platine (1) est fabriquée sous forme de plaque composite à plusieurs couches.

15. Procédé selon l'une des revendications précédentes, **caractérisé en ce que** la platine (1) est fabriquée à partir d'un matériau perméable aux ondes électromagnétiques.

16. Procédé selon l'une des revendications 1 à 13 ou 14 ou 15, **caractérisé en ce que**, au-dessus d'une autre platine munie d'une couche de métal, est disposé un autre composant, muni d'une couche de matériau de brasage, composant à fixer sur l'autre platine, la couche de métal et la couche de matériau de brasage se trouvant en confrontation, espacées verticalement, sans contact, et **en ce que** l'autre platine est disposée au-dessus de la platine (1), et un faisceau de rayons d'ondes électromagnétiques est dirigé à travers les deux platines sur la couche de matériau de brasage de l'autre composant pour obtenir son chauffage à fusion, afin de former une goutte de matériau de brasage (5') devant assurer la fixation sur l'autre platine.

# *Fig.1*

(a)

(b)

(c)

# *Fig.2*

Fig.3

Fig.4